# DEMANDE DE BREVET EUROPEEN

(11) **EP 3 667 739 A1**
(43) Date de publication de la demande: **17.06.2020**
(21) Numéro de dépôt: 19214042.4
(22) Date de dépôt: 06.12.2019
(51) Int. Cl.: H01L 31/0236, H01L 31/0392, H02S 20/26

(54) **DISPOSITIF OPTRONIQUE**

(30) Priorité: 10.12.2018 FR 1872611
(71) Demandeur: COMMISSARIAT À L'ÉNERGIE ATOMIQUE ET AUX ÉNERGIES ALTERNATIVES, 75015 Paris (FR)
(72) Inventeur: DUCROS, Cédric, 38054 GRENOBLE cedex 09 (FR); DUNOYER, Nicolas, 38054 GRENOBLE cedex 09 (FR); OLLIER, Emmanuel, 38054 GRENOBLE cedex 09 (FR); SZAMBOLICS, Helga, 38054 GRENOBLE cedex 09 (FR)
(74) Mandataire: Guérin, Jean-Philippe

(57) **Abrégé**

L'invention concerne un dispositif optronique (1), comprenant :
-un substrat de verre (2) comportant des première et deuxième faces (21, 22) opposées et texturées ;
-un matériau conducteur électrique (3) continu et formé sur la deuxième face (22) du substrat de verre ;
-un capteur photovoltaïque en couche mince (4) formé sur le matériau conducteur électrique (3);
-la texturation de la première face (21) du substrat de verre est configurée pour présenter une réflexion optique pondérée dans le spectre visible inférieure à 3%;
-la texturation de la deuxième surface (22) du substrat de verre est configurée pour diffuser la lumière transmise depuis le substrat vers l'électrode transparente (3).

## Description

L'invention concerne les transducteurs photovoltaïques, et en particulier de tels transducteurs présentant un substrat et une électrode transparents.

Un dispositif optronique comprend usuellement un substrat transparent, un capteur photovoltaïque pour absorber la lumière et la convertir en électricité, et une électrode transparente pour collecter l'électricité générée, l'électrode étant disposée entre le substrat et le capteur photovoltaïque.

Un substrat transparent est généralement réalisé en verre, tel qu'un verre borosilicate ou sodocalcique. Une électrode transparente est fréquemment réalisée en oxyde transparent conducteur tel que de l'oxyde d'indium dopé, de l'oxyde de zinc dopé, ou de l'oxyde d'étain dopé.

Les transitions d'indice de réfraction aux interfaces à l'intérieur du transducteur, sont à l'origine de réflexions lumineuses. De telles réflexions lumineuses réduisent d'une part le rendement de conversion du dispositif optronique, une quantité réduite de lumière atteignant le capteur photovoltaïque. Les réflexions lumineuses peuvent aussi s'avérer gênantes pour l'environnement dans certaines applications, en générant un éblouissement ou en rendant le dispositif optronique.

Une solution connue pour réduire la transmission à l'interface entre l'air et le substrat de verre est de déposer des couches multiples anti-reflets avec des indices de réfraction inférieurs à celui du substrat de verre, ces indices étants décroissants plus ils sont éloignés du substrat. De telles couches anti-reflets présentent une efficacité très variable en fonction de l'angle d'incidence de la lumière par rapport au substrat de verre, ou encore très variable en fonction de la longueur d'onde de cette lumière. Par ailleurs, de telles couches ne sont pas forcément adaptées pour une application entre le substrat et l'électrode.

Une autre solution connue consiste à réaliser une texturation au niveau d'une interface du dispositif optronique, par exemple au niveau de l'interface avec l'air du substrat en verre. Une telle interface texturée permet d'obtenir un indice de réfraction intermédiaire au niveau de l'interface, ce qui permet de réduire la réflexion. Une telle interface présente une moindre sensibilité à l'angle d'incidence de la lumière par rapport au substrat de verre.

Un procédé de texturation d'une face du verre formant interface air/verre est notamment décrit dans le document 'Optimal Moth Eye Nanostructure Array on Transparent Glass Towards Broadband Antireflection', publié par Seungmuk Ji et al, dans la revue ACS Applied Material Interfaces, en 2013, 5, pages 10731-10737. Selon ce procédé, on réalise un masquage du verre selon un motif, puis une gravure partielle du verre selon ce motif de façon à obtenir une texture régulière.

Le document 'Antireflective grassy surface on glass substrates with self-masked dry etching', publié par M. Song et al, dans Nanoscale Research Letters 2013, 8:505, décrit un procédé de texturation d'une face du verre formant interface air/verre. Ce procédé est basé sur une gravure sèche, de type gravure par ion réactif dans un mélange CF4/O2, et permet de simplifier le procédé de fabrication en évitant l'utilisation de masques.

Le document 'SF6/Ar Plasma textured periodic glass surface morphologies with high transmittance and haze ratio of ITO :ZR films for amorphous silicon thin film solar cells' par Hussain et al, publié dans Vacuum 117 pages 91 à 97, décrit un procédé de texturation d'un panneau de verre pour obtenir une diffusion par du TCO déposé sur la texture formée. Ce document propose un procédé de gravure sèche à travers un masque de gravure. Un tel procédé est relativement complexe à mettre en œuvre. De plus, le procédé mis en œuvre a tendance à dégrader la transmission optique au niveau de l'interface avec l'électrode par rapport à un substrat lisse. Cela peut affecter le rendement de conversion du dispositif optronique, en particulier lorsque le capteur photovoltaïque est du type en couche mince.

Ainsi, aucune solution connue ne permet à la fois d'obtenir un effet antireflet efficace à l'interface air/verre et d'accroître significativement le rendement de conversion du dispositif optronique.

L'invention vise à résoudre un ou plusieurs de ces inconvénients. L'invention porte ainsi sur un dispositif optronique, tel que défini dans les revendications annexées.

L'homme du métier comprendra que chacune des caractéristiques d'une revendication dépendante ou de la description peut être combinée indépendamment aux caractéristiques d'une revendication indépendante, sans pour autant constituer une généralisation intermédiaire.

L'invention concerne également un procédé de fabrication d'un dispositif optronique, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
[Fig.1] est une vue en coupe schématique d'un exemple de dispositif optronique selon un mode de réalisation de l'invention ;
[Fig.2] est une vue en coupe schématique d'un exemple de dispositif optronique selon un autre mode de réalisation de l'invention ;
[Fig.3],

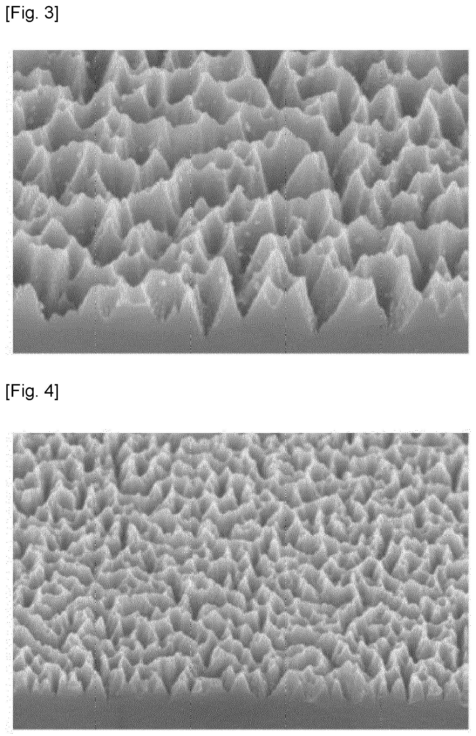

[Fig.4] et

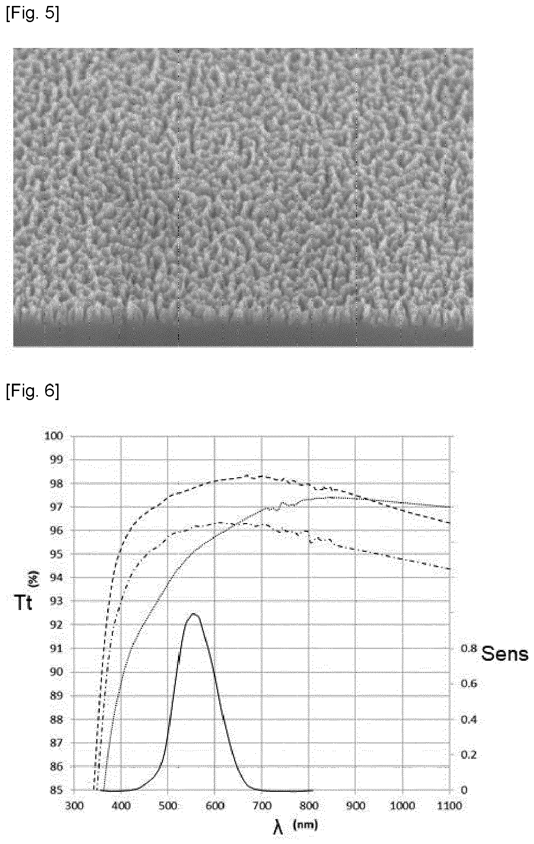

[Fig.5] sont des vues au microscope électronique à balayage de faces de verre texturées selon différents procédés de fabrication ;
[Fig.6],

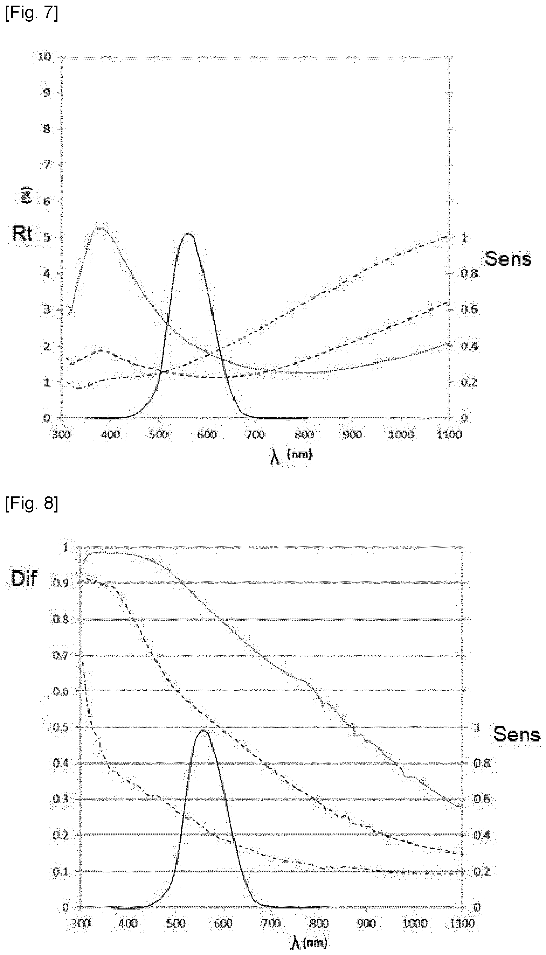

[Fig.7] et
[Fig.8] sont des diagrammes illustrant différents paramètres optiques des faces de verre texturées illustrées aux figures 3 à 5 ;

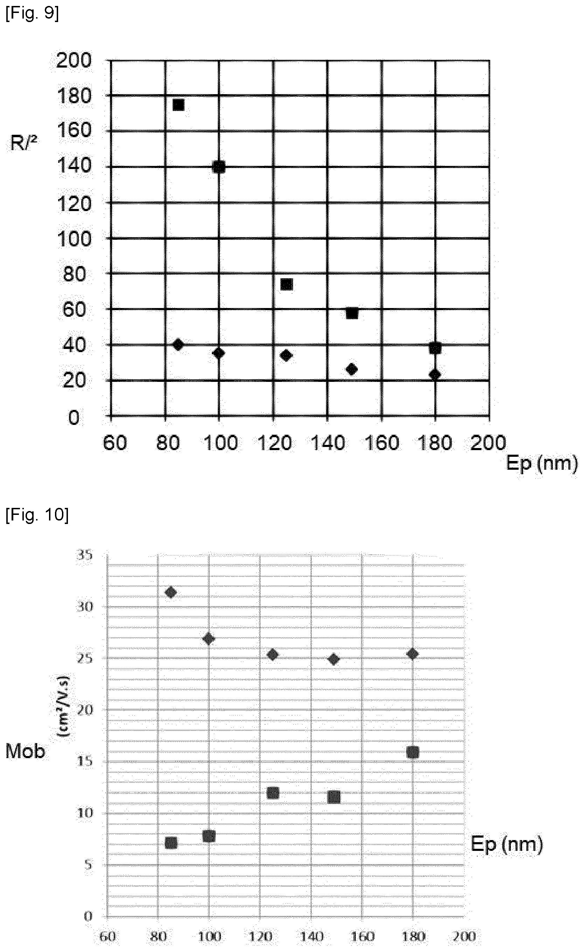

[Fig.9] est un diagramme comparant l'influence de l'épaisseur d'un matériau conducteur électrique sur sa résistance, pour un dispositif optronique selon l'invention et un dispositif optronique de l'état de la technique ;
[Fig.10] est un diagramme comparant l'influence de l'épaisseur d'un matériau conducteur électrique sur sa mobilité électronique, pour un dispositif optronique selon l'invention et un dispositif optronique de l'état de la technique ;

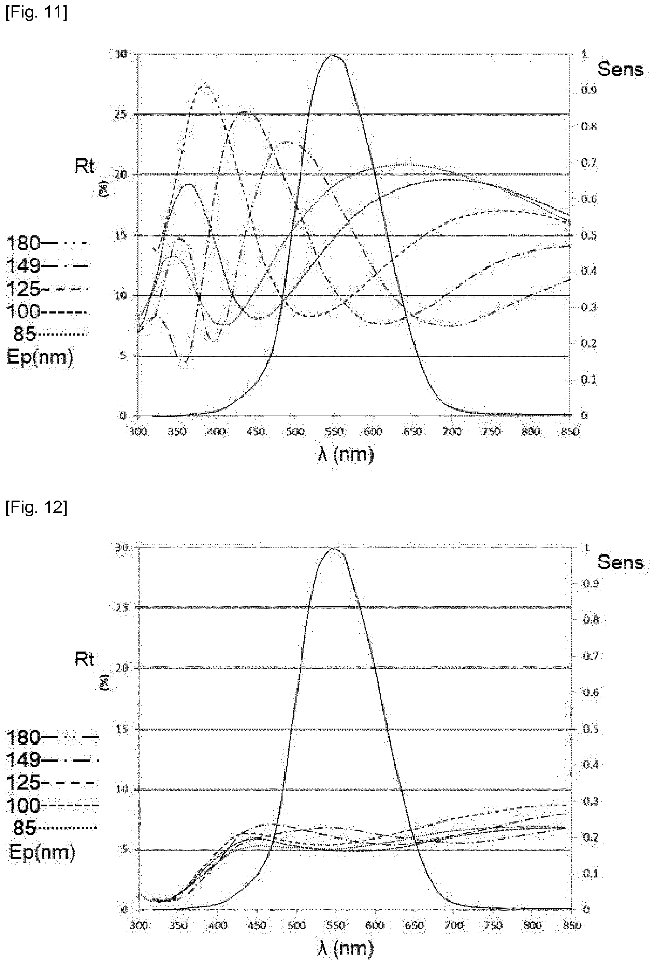

[Fig.11] est un diagramme spectral de la réflexion sur matériau conducteur électrique déposé sur un substrat de l'état de la technique, en fonction de l'épaisseur de ce matériau conducteur électrique;
[Fig.12] est un diagramme spectral de la réflexion optique sur un matériau conducteur électrique déposé sur un substrat pour un dispositif optronique selon l'invention, en fonction de l'épaisseur de ce matériau conducteur électrique ;

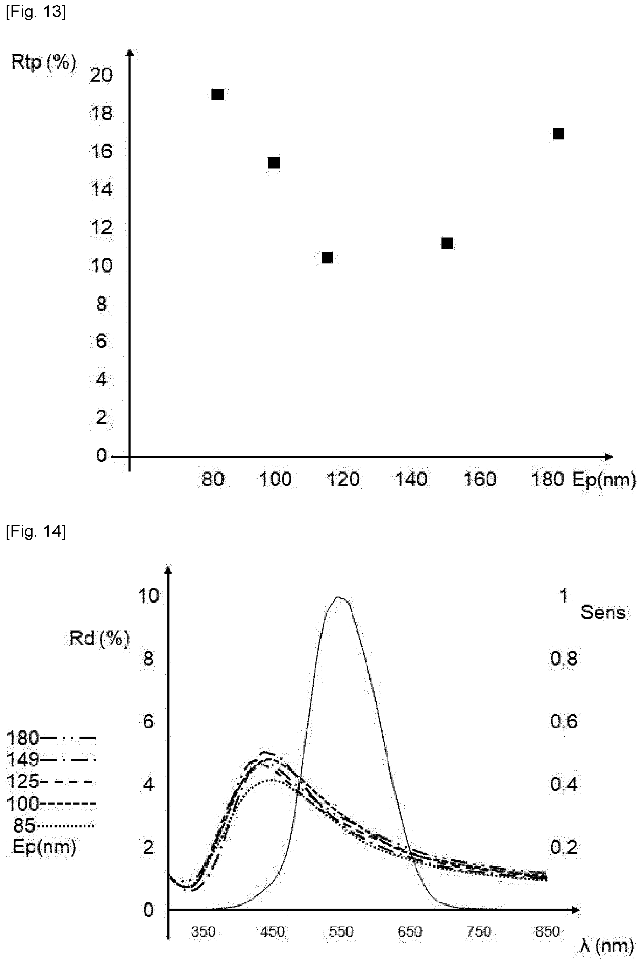

[Fig.13] est un diagramme spectral de la réflexion optique sur un matériau conducteur électrique déposé sur un substrat pour un dispositif optronique selon l'invention, en fonction de l'épaisseur de ce matériau conducteur électrique, avec une pondération par la sensibilité spectrale humaine ;
[Fig.14] est un diagramme de la réflexion optique diffuse pour différentes épaisseurs d'un matériau conducteur électrique déposé sur un substrat texturé, pour un dispositif optronique selon l'invention, en fonction de la longueur d'onde.

On désignera une face texturée comme une face présentant une rugosité ou un relief par rapport à une forme géométrique lisse.

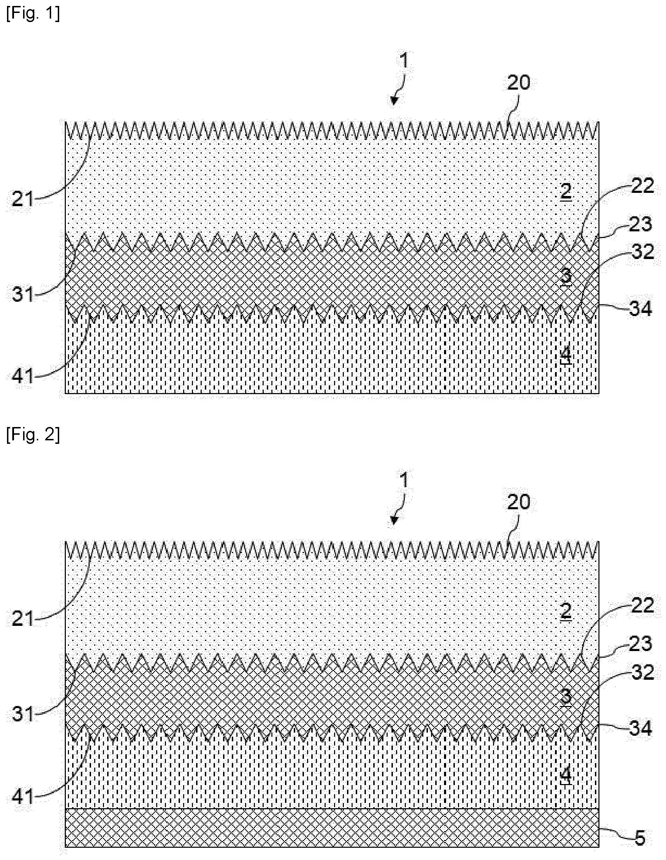

La figure 1 est une vue en coupe schématique d'un exemple d'un dispositif optronique 1 selon un mode de réalisation de l'invention. Le capteur photovoltaïque 1 comprend un substrat de verre 2, un matériau conducteur électrique ou électrode transparente 3 et un capteur photovoltaïque 4. L'électrode transparente 3 est positionnée en contact entre le substrat de verre 2 et le capteur photovoltaïque 4.

Le substrat 2 est par exemple réalisé en verre borosilicate ou en verre sodocalcique. Le substrat de verre 2 comporte une face externe 21 en contact avec l'air au niveau d'une interface 20, et une face interne 22 en contact avec l'électrode 3 au niveau d'une interface 23. Les faces 21 et 22 sont opposées et texturées.

L'électrode transparente 3 est continue, afin de pouvoir collecter et conduire les charges électriques générées par captage de photons par le capteur photovoltaïque 4. L'électrode 3 est par exemple réalisée en un oxyde conducteur tel que l'oxyde de zinc dopé, l'oxyde d'étain dopé, ou l'oxyde d'indium dopé. L'électrode transparente peut également être réalisée en un alliage de ces matériaux, par exemple en ITZO. L'électrode transparente 3 comporte une face 31 en contact avec la face 22 et de forme complémentaire. L'électrode transparente 3 comporte également une face 32, opposée à la face 31.

Le capteur photovoltaïque 4 est de type en couche mince, pour des raisons de compacité. Un capteur photovoltaïque 4 sera typiquement considéré comme en couche mince s'il présente une épaisseur inférieure à 10 µm. Du fait de sa faible épaisseur, le capteur photovoltaïque 4 présente potentiellement une capacité de conversion de lumière en charges électriques relativement réduite. La transmission lumineuse à travers le substrat 2 et l'électrode 3 est donc particulièrement importante en vue d'accroître le rendement de conversion du capteur photovoltaïque 4. Le capteur photovoltaïque 4 peut également être de type en couche mince semi transparent, l'amélioration du rendement de conversion de lumière en charges électriques étend alors encore plus importante. Le capteur photovoltaïque 4 peut présenter une composition connue en soi, par exemple inclure du silicium amorphe hydrogéné en couche fine (a-Si :H).

La figure 2 est une vue en coupe schématique d'un exemple d'un capteur photovoltaïque 1 selon un autre mode de réalisation de l'invention. Dans ce mode de réalisation, le capteur photovoltaïque 4 est disposé entre l'électrode transparente 3 est une couche anti reflet 5. Le capteur photovoltaïque 1 du deuxième mode de réalisation reprend la structure du substrat 2, de l'électrode 3 et du capteur photovoltaïque 4 du premier mode de réalisation à l'identique. La couche anti reflet 5 est avantageusement réalisée dans le même matériau que l'électrode 3. La couche anti reflet 5 pourra présenter une épaisseur identique à celle de l'électrode 3, à +/- 20%. Des échantillons ont notamment été réalisés avec une couche anti reflet 5 en oxyde d'indium dopé présentant une épaisseur de 252 nm, ou du en ITZO présentant une épaisseur de 235nm.

La face 21 présente une texturation appropriée qui lui permet d'obtenir un effet anti-reflet pour une grande gamme d'angles d'incidence. Un tel effet anti-reflet est notamment bien moins sensible à l'angle d'incidence lumineux ou à la longueur d'onde de la lumière incidente que des dépôts de couches avec des gradients d'indice sur un substrat de verre. La texturation sera avantageusement configurée de sorte que la réflexion optique pondérée par la sensibilité spectrale humaine, au niveau de la face 21, est inférieure à 3 %. Ainsi, la texturation de la face 21 permet d'éviter un éblouissement ou permet de rendre le capteur 1 peu détectable. La réflexion optique peut se décomposer en la réflexion optique spéculaire et la réflexion optique diffuse. De préférence, la texturation de la face 21 est configurée de sorte que la proportion de réflexion diffuse dans la réflexion optique totale (pondérée par la sensibilité spectrale humaine) est au moins égale à 45 %. Ainsi, la face 21 est encore moins détectable et limite davantage le risque d'éblouissement. La sensibilité spectrale humaine correspondra par exemple à un modèle de sensibilité pour la vision photopique, par exemple la fonction V(À) définie par l'ISO.

La face 22 présente une texturation appropriée qui lui permet d'obtenir un effet de transmission optique vers l'électrode transparente 3, avec une diffusion. Ainsi, en diffusant la lumière transmise dans l'électrode 3, on accroît en pratique la probabilité d'absorption d'un photon incident dans le capteur photovoltaïque 4, et donc le rendement de conversion. Ceci s'avère particulièrement avantageux avec un capteur photovoltaïque 4 en couche mince. Avantageusement, la texturation de la face 22 est configurée de sorte que la proportion de transmission diffuse dans la transmission optique totale (pondérée par la sensibilité spectrale humaine) est au moins égale à 45 %.

Avantageusement, les texturations des faces 21 et 22 sont configurées de sorte que :
- la réflexion optique, pondérée par la sensibilité spectrale humaine, de la face 21 est inférieure à celle de la face 22 ;
- la proportion de réflexion diffuse dans la réflexion optique totale (pondérée par la sensibilité spectrale humaine) de la face 22 est supérieure à celle de la face 21.

Les figures 3 à 5 sont des vues au microscope à balayage à une même échelle, de la surface de substrats de verre ayant fait l'objet de gravures plasma de texturation avec différents paramètres, selon des procédés détaillés par la suite.

De tels substrats ont permis de réaliser un certain nombre d'expérimentations pour déterminer leur influence sur des paramètres optiques ou électriques d'un capteur photovoltaïque. Les résultats de différentes expérimentations sont notamment illustrés dans les diagrammes des figures 6 à 14.

Pour l'exemple illustré à la figure 3, le pas moyen entre les motifs du relief de texturation est de 300 nm. La hauteur des motifs du relief est comprise entre 330 et 600 nanomètres, avec une moyenne estimée à 465 nm. Le rapport hauteur sur pas des motifs du relief est égal à 1,55.

Pour l'exemple illustré à la figure 4, le pas moyen entre les motifs du relief est de 160 nm. La hauteur des motifs du relief est comprise entre 170 et 340 nanomètres, avec une moyenne estimée à 255 nm. Le rapport hauteur sur pas des motifs du relief est égal à 1,59.

Pour l'exemple illustré à la figure 5, le pas moyen entre les motifs du relief est de 80 nm. La hauteur des motifs du relief est comprise entre 100 et 200 nanomètres, avec une moyenne estimée à 150 nm. Le rapport hauteur sur pas des motifs du relief est égal à 1,87.

Pour ces trois exemples de texturation, la figure 6 illustre le taux Tt de transmission totale, la figure 7 illustre le taux Rt de réflexion total, et la figure 8 illustre le rapport Dif entre la réflexion diffuse et la réflexion totale. La courbe en pointillés correspond à l'exemple de la figure 3, la courbe en trait discontinu correspond à l'exemple de la figure 4 et la courbe en tiret point correspond à l'exemple de la figure 5. Dans chacun des diagrammes des figures 6 à 8, la courbe en trait plein correspond à la sensibilité spectrale humaine Sens, selon la fonction V(À) définie par l'ISO.

Comme le montre la figure 6, une texturation d'une face de verre selon les exemples des figures 3 à 5 permet d'obtenir une transmission optique relativement élevée et assez constante, en particulier dans le spectre optique.

Différents paramètres optiques pour les exemples des figures 3 à 5 sont synthétisés dans le tableau suivant :

**[Tableaux 1]**

| Exemple : | FiG.3 | FiG.4 | FiG.5 |
|---|---|---|---|
| Réflexion RTP totale en %, pondérée par la sensibilité | 2,16 | 1,23 | 1,59 |
| Réflexion totale minimale en %, sur la plage 400-800nm | 1,28 | 1,16 | 1,11 |
| Longueur d'onde en nm, pour une réflexion totale minimale | 785 | 610 | 320 |
| Réflexion RDP diffuse en %, pondérée par la sensibilité | 1,84 | 0,66 | 0,35 |
| Rapport en pour cent, entre RDP et RTP | 85,2 | 53,7 | 22 |

La valeur de réflexion RTP sur une face externe d'un substrat de verre non traité et non texturé est usuellement de l'ordre de 8%. Le rapport RDP/RTP pour ce même substrat de verre non traité et non texturé serait usuellement de l'ordre de 1%.

La configuration de la figure 4 sera avantageusement utilisée pour la texturation de la face 21. En effet, la configuration obtenue présente la transmission la plus élevée et la plus constante sur le spectre visible, le niveau de réflexion le plus bas sur le spectre visible, et un rapport RDP/RTP relativement élevé. Une telle configuration s'avère donc particulièrement appropriée pour une propriété anti-reflet.

La configuration de la figure 3 sera avantageusement utilisée pour la texturation de la face 22. Une telle configuration s'avère en effet optimale pour transmettre de la lumière avec diffusion à l'interface entre l'électrode 3 et le substrat 2. Ainsi, la quantité de lumière qu'est susceptible de capter le capteur photovoltaïque 4 est accrue (de même que le rendement de conversion), ce qui s'avère particulièrement avantageux pour un capteur photovoltaïque 4 en couche mince.

L'électrode transparente 3 doit présenter une résistance par carré réduite, typiquement inférieure à 100 Ω/carré, de façon à collecter de façon optimale les charges électriques générées au niveau du capteur photovoltaïque 4. Par contre, comme illustré par le diagramme de la figure 11, l'épaisseur Ep d'une électrode sur un substrat de verre lisse de l'état de la technique affecte fortement la réflexion optique totale Rt. Par conséquent, un compromis doit usuellement être trouvé entre une épaisseur importante favorisant une faible résistance électrique, et une épaisseur réduite favorisant une faible réflexion optique. La courbe en trait plein correspond à la sensibilité spectrale humaine Sens, selon la fonction V(À) définie par l'ISO.

Par ailleurs, le diagramme de la figure 9 compare la résistance par carré d'une électrode transparente dans le cas d'un dépôt sur un substrat de verre lisse (losanges) et dans le cas d'un dépôt sur un substrat de verre texturé (carrés) correspondant à l'exemple de la figure 3, en fonction de l'épaisseur Ep de cette électrode. Dans le cas de l'invention, on constate une diminution exponentielle de la résistance par carré en fonction de l'épaisseur, la diminution de la résistance par carré selon l'état de la technique étant linéaire. On constate également une résistance par carré très supérieure avec un substrat de verre texturé par rapport à un substrat lisse, pour des électrodes de faibles épaisseurs. On constate également une résistance par carré beaucoup plus proche entre un substrat de verre texturé par rapport à un substrat lisse, pour des électrodes de fortes épaisseurs.

Le diagramme de la figure 10 compare la mobilité électronique Mob d'une électrode transparente dans le cas d'un dépôt sur un substrat de verre lisse (losanges) et dans le cas d'un dépôt sur un substrat de verre texturé (carrés) correspondant à l'exemple de la figure 3, en fonction de l'épaisseur Ep de cette électrode. La mobilité électronique Mob augmente avec l'épaisseur Ep. La mobilité électronique pour un substrat de verre selon l'invention est fortement réduite par rapport à celle obtenue pour un substrat de verre lisse.

Cependant, comme de fortes valeurs d'épaisseur d'électrode ont tendance à accroître la réflexion optique selon l'enseignement de la figure 11 et tendance à réduire la mobilité électronique selon l'enseignement de la figure 12, on est a priori dissuadé d'utiliser la texturation selon l'invention, qui impliquerait a priori soit de dégrader la résistance par carré à faible épaisseur, soit de dégrader la réflexion optique à forte épaisseur.

Le diagramme de la figure 12 illustre la faible influence de l'épaisseur Ep de l'électrode sur la réflexion optique totale Rt pour un substrat de verre texturé correspondant à l'exemple de la figure 3. Par conséquent, une électrode 3 pour un dispositif optronique 1 selon l'invention peut présenter une épaisseur importante pour favoriser une résistance par carré réduite, sans pour autant accroître la réflexion optique. On peut également noter que la configuration de la texturation de la face 22 du substrat 2 est le paramètre prépondérant pour définir la réflexion optique totale à l'interface 23.

Le diagramme de la figure 13 illustre la réflexion optique totale, pondérée par la sensibilité spectrale humaine, en fonction de l'épaisseur de l'électrode 3 formée sur un substrat de verre texturé correspondant à l'exemple de la figure 3. Une épaisseur optimale de 136nm pour l'électrode 3 a été calculée par simulation. Une telle épaisseur permet de disposer d'une résistance par carré d'environ 60 Ω/carré pour l'électrode 3. De façon générale, on utilisera avantageusement une électrode 3 présentant une épaisseur au moins égale à 120nm, de façon préférentielle au moins égale à 150 nm.

Le diagramme de la figure 14 illustre la réflexion optique diffuse pour différentes épaisseurs Ep de l'électrode 3 déposées sur un substrat texturé correspondant à l'exemple de la figure 3, en fonction de la longueur d'onde. La courbe en trait plein correspond à la sensibilité spectrale humaine Sens. On constate une très faible influence de l'épaisseur de l'électrode 3 sur la réflexion optique diffuse. Par ailleurs, la proportion de cette réflexion optique diffuse par rapport à la réflexion optique totale s'est avérée au moins égale à 40%, alors que cette proportion est proche de 0 pour une électrode ménagée sur un substrat lisse. Par conséquent, l'épaisseur de l'électrode 3 ne nuit pas aux propriétés d'anti-éblouissement ou de furtivité correspondantes. On peut également noter que la configuration de la texturation de la face 22 du substrat 2 est le paramètre prépondérant pour définir la proportion de la réflexion optique diffuse à l'interface 23.

Avantageusement, la face 32 de l'électrode 3 présente une texturation appropriée, permettant d'obtenir un effet de transmission optique vers le capteur photovoltaïque 4, avec une diffusion. Ainsi, en diffusant la lumière transmise dans le capteur photovoltaïque 4, on accroît en pratique la probabilité d'absorption d'un photon incident dans ce capteur photovoltaïque 4, et donc le rendement de conversion. Ceci s'avère particulièrement avantageux avec un capteur photovoltaïque 4 en couche mince. Avantageusement, la face 32 est texturée de sorte que la proportion de transmission diffuse dans la transmission optique totale (pondérée par la sensibilité spectrale humaine) est au moins égale à 45 %.

Avantageusement, la face 32 est également texturée de sorte que la proportion de réflexion diffuse dans la réflexion optique totale (pondérée par la sensibilité spectrale humaine) est au moins égale à 45 %.

Par ailleurs, une texturation avec des reliefs plus profonds au niveau de la face 22 permet de conserver une texturation au niveau de l'interface entre l'électrode 3 déposée et le capteur photovoltaïque 4. En effet, pour un dépôt d'une électrode 3 relativement fine (typiquement inférieure à 1µm), au moins une partie du relief de la face 22 est conservée au niveau de l'interface 340. Ainsi, la transmission optique entre l'électrode 3 et le capteur photovoltaïque 4 est optimisée.

De plus, afin de conserver une texturation de la face 32 par un simple dépôt du matériau de l'électrode 3 sur la face 22, l'épaisseur de l'électrode 3 est avantageusement au plus égale à la profondeur de la texturation de la face 22.

Par ailleurs, pour favoriser la continuité de l'électrode 3, celle-ci présentera avantageusement une épaisseur au moins égale à 25% de la profondeur de la texturation de la face 22.

D'autres mesures comparatives de performances ont été réalisées avec quatre échantillons de test :
- un premier échantillon avec un substrat de verre présentant des faces lisses, une électrode conductrice transparente en AZO d'une épaisseur de 269 nm, un dispositif optronique incluant une couche de silicium amorphe hydrogéné en couche fine, et une couche anti reflet en AZO d'une épaisseur de 252 nm ;
- un deuxième échantillon avec un substrat de verre présentant des faces lisses, une électrode conductrice transparente en ITZO d'une épaisseur de 254 nm, un dispositif optronique incluant une couche de silicium amorphe hydrogéné en couche fine, et une couche anti reflet en ITZO d'une épaisseur de 235 nm ;
- un troisième échantillon avec un substrat de verre 2 présentant des faces texturées, une électrode 3 en AZO d'une épaisseur de 269 nm, un capteur photovoltaïque 4 incluant une couche de silicium amorphe hydrogéné en couche fine, et une couche anti reflet 5 en AZO d'une épaisseur de 252 nm (exemple de structure selon le deuxième mode de réalisation) ;
- un quatrième échantillon avec un substrat de verre 2 présentant des faces texturé, une électrode 3 en ITZO d'une épaisseur de 254 nm, un capteur photovoltaïque 4 incluant une couche de silicium amorphe hydrogéné en couche fine, et une couche anti reflet 5 en ITZO d'une épaisseur de 235 nm.

**[Tableaux 2]**

| Exemple : | Voc (V) | Jsc (mA/cm²) | RdtC (%) | Rs (Ω/carré) |
|---|---|---|---|---|
| Échantillon 1 | 0,91 | 7,9 | 4 | 21,7 |
| Échantillon 2 | 0,84 | 7,5 | 3,5 | 28,9 |
| Échantillon 3 | 0,87 | 11,1 | 4,9 | 43 |
| Échantillon 4 | 0,7 | 11,2 | 3,9 | 171,4 |

On constate qu'un certain nombre de paramètres électriques sont a priori moins bon pour les échantillons correspondant à des dispositifs optroniques selon l'invention : une tension de cellule Voc inférieure et une résistance par carré Rs supérieure. Cependant, on constate que le rendement de conversion RdtC et la densité de courant Jsc générés par les capteurs photovoltaïques selon l'invention sont en pratique améliorés. En pratique, la dégradation des propriétés électriques est très largement compensée par une amélioration des propriétés optiques (accroissement sensible de la probabilité de capture d'un photon dans le dispositif optronique notamment) dans les dispositifs optroniques selon l'invention.

Le procédé de fabrication du dispositif optronique peut mettre en œuvre des étapes spécifiques de texturation des faces 21 et 22 du substrat de verre 2.

Afin de disposer d'un procédé de fabrication à la fois simple et peu coûteux, la texturation des faces 21 et 22 du substrat de verre 2 est avantageusement réalisée sans masquage et avec une même technologie de gravure. Avantageusement, la texturation des faces 21 et 22 est mise en œuvre par une gravure sèche de type plasma sous vide. Une telle gravure permet notamment de réaliser la texturation sans passer la température de transition vitreuse du verre. Avantageusement, une telle gravure est mise en œuvre pendant une durée d'au plus 30 minutes.

Des résultats d'expérimentations ont permis de déterminer que des paramètres de gravure telle que la pression, le type de mélange gazeux, la tension de polarisation et la durée de gravure permettait de modifier des paramètres de la rugosité de la face gravée. Des paramètres de rugosité de la face gravée peuvent ainsi être modifiés, tels que le pas des reliefs, la hauteur des reliefs, la largeur des reliefs et/ou le rapport hauteur/largeur des reliefs.

Des expérimentations ont ainsi été notamment menées avec des paramètres de gravure plasma suivants, sur des verres de type alumino-borosilicate :
- un mélange gazeux de CHF₃/O₂, avec un rapport de mélange compris entre 10 et 15 ;
- une pression de travail comprise entre 50 et 200mTorr ;
- une densité de puissance radiofréquence comprise entre 1,65 et 3,56W/cm² ;
- une durée de gravure comprise entre 10 et 30 min.

Dans l'exemple illustré à la figure 3, les paramètres de gravure utilisés sont les suivants :
- un rapport du mélange CHF₃/O₂ de 10 ;
- une pression de travail de 200 mTorr ;
- une densité de puissance de 3,56W/cm² ;
- une durée de traitement de 30 minutes.

Dans l'exemple illustré à la figure 4, les paramètres de gravure utilisés sont les suivants :
- un rapport du mélange CHF₃/O₂ de 12 ;
- une pression de travail de 100 mTorr ;
- une densité de puissance de 2,45W/cm² ;
- une durée de traitement de 20 minutes.

Dans l'exemple illustré à la figure 5, les paramètres de gravure utilisés sont les suivants :
- un rapport du mélange CHF₃/O₂ de 15 ;
- une pression de travail de 50 mTorr ;
- une densité de puissance de 1,65W/cm² ;
- une durée de traitement de 10 minutes.

Le procédé de fabrication du dispositif optronique 1 peut mettre en œuvre des étapes spécifiques de dépôt de l'électrode 3 après la texturation de la face 22. L'électrode 3 peut par exemple être formée par dépôt par pulvérisation magnétron d'un film conducteur transparent sur la face texturée 22. Le matériau de l'électrode 3 peut être connu en soi, par exemple un oxyde de zinc dopé, un oxyde d'étain dopé, ou un oxyde d'indium dopé.

Avantageusement, l'électrode 3 déposée doit garantir une résistance par carré au plus égale à 100 Ω/carré. Une telle résistance de l'électrode 3 permet de collecter de façon optimale les charges électriques générées au niveau du capteur photovoltaïque 4.

Avantageusement, l'électrode 3 déposée doit présenter une réflexivité optique minimale sur une plage de longueur d'onde centrée autour de 550 nm.

Le procédé de fabrication du dispositif optronique selon l'invention peut mettre en œuvre une étape de dépôt connu en soi d'un capteur photovoltaïque 4 en couche mince. Un procédé de dépôt connu en soi de silicium amorphe hydrogéné en couche fine (a-Si :H) sur une électrode peut ainsi être mis en œuvre.

## Revendications

1. [Dispositif optronique (1), comprenant :
- un substrat de verre (2) comportant des première et deuxième faces (21, 22) opposées et texturées ;
- un matériau conducteur électrique (3) continu et formé sur la deuxième face (22) du substrat de verre ;
- un capteur photovoltaïque en couche mince (4) formé sur le matériau conducteur électrique (3);
**caractérisé en ce que** :
- la texturation de la première face (21) du substrat de verre est configurée pour présenter une réflexion optique pondérée dans le spectre visible inférieure à 3%;
- la texturation de la deuxième surface (22) du substrat de verre est configurée pour diffuser la lumière transmise depuis le substrat vers l'électrode transparente (3).

2. Dispositif optronique (1) selon la revendication 1, dans lequel une interface de contact (34) entre le capteur photovoltaïque (4) et le matériau conducteur électrique (3) est texturée pour diffuser la lumière transmise depuis l'électrode transparente vers le capteur photovoltaïque (4).

3. Dispositif optronique (1) selon la revendication 1 ou 2, dans lequel la texturation de la deuxième surface (22) est configurée pour que la proportion de transmission diffuse vers le matériau conducteur électrique (3), par rapport à la transmission optique totale pondérée par la sensibilité spectrale humaine, soit au moins égale à 45 %.

4. Dispositif optronique (1) selon l'une quelconque des revendications précédentes, dans lequel la première face (21) du substrat de verre (2) est texturée de sorte que la réflexion optique de la lumière incidente pondérée par la sensibilité spectrale humaine sur cette première face (21) comprenne au moins 45% de réflexion diffuse.

5. Dispositif optronique (1) selon l'une quelconque des revendications précédentes, dans lequel la réflexion optique pondérée par la sensibilité spectrale humaine de la première face (21) est inférieure à celle de la deuxième face (22).

6. Dispositif optronique (1) selon l'une quelconque des revendications précédentes, dans lequel la proportion de réflexion diffuse dans la réflexion optique totale pondérée par la sensibilité spectrale humaine de la deuxième face (22) est supérieure à celle de la première face (21).

7. Dispositif optronique (1) selon l'une quelconque des revendications précédentes, dans lequel le matériau conducteur électrique (3) présente une épaisseur au moins égale à 120 nm.

8. Dispositif optronique (1) selon l'une quelconque des revendications précédentes, dans lequel le matériau conducteur électrique (3) présente une épaisseur au moins égale à 25% de la profondeur de la texturation de ladite deuxième face (22).

9. Dispositif optronique (1) selon l'une quelconque des revendications précédentes, dans lequel le matériau conducteur électrique (3) présente une épaisseur au plus égale à une profondeur de la texturation de ladite deuxième face (22).

10. Dispositif optronique (1) selon l'une quelconque des revendications précédentes, dans lequel le matériau conducteur électrique (3) est réalisé dans un matériau choisi dans le groupe constitué de l'oxyde de zinc dopé, de l'oxyde d'étain dopé, de l'oxyde d'indium dopé et de leurs alliages.

11. Dispositif optronique (1) selon l'une quelconque des revendications précédentes, dans lequel ledit capteur photovoltaïque (4) comprend du silicium amorphe hydrogéné en couche fine (a-Si :H).

12. Dispositif optronique (1) selon l'une quelconque des revendications précédentes, dans lequel ledit capteur photovoltaïque (4) est recouvert d'une couche anti reflet réalisé dans le même matériau que le matériau conducteur électrique (3).

13. Procédé de fabrication d'un dispositif optronique (1), comprenant les étapes de :
- texturer une première face (21) par gravure plasma d'un substrat de verre (2) de sorte que cette première face présente une réflexion optique pondérée par la sensibilité spectrale humaine inférieure à 3 % ;
- texturer une deuxième face (22) par gravure plasma du substrat de verre (2) pour obtenir une texturation différente de celle de la première face, de sorte que cette deuxième face diffuse la lumière transmise à travers le substrat (22);
- déposer une couche conductrice transparente sur la deuxième face (22) du substrat (2) de façon à former matériau conducteur électrique (3) ;
- former un capteur photovoltaïque en couche mince (4) sur le matériau conducteur électrique (3).

14. Procédé de fabrication d'un dispositif optronique (1) selon la revendication 13, dans lequel lesdites étapes de texturation sont réalisées sans masquage des faces du substrat de verre (2).

15. Procédé de fabrication d'un dispositif optronique (1) selon la revendication 13 ou 14, dans lequel l'épaisseur de la couche conductrice transparente déposée est au moins égale à 120 nm.
